(19) Europäisches Patentamt / European Patent Office / Office européen des brevets

(11) **EP 3 242 391 B1**

(12) **EUROPEAN PATENT SPECIFICATION**

(45) Date of publication and mention
of the grant of the patent:
**04.03.2020 Bulletin 2020/10**

(51) Int Cl.:
*H02M 7/487* (2007.01)    *G01R 31/42* (2006.01)
*G01R 31/02* (2006.01)

(21) Application number: **16168003.8**

(22) Date of filing: **03.05.2016**

(54) **METHOD FOR MONITORING CHANGE IN CAPACITANCE IN ELECTRIC SYSTEM AND ELECTRIC SYSTEM**

VERFAHREN ZUR ÜBERWACHUNG VON KAPAZITÄTSVERÄNDERUNGEN IN EINEM ELEKTRISCHEN SYSTEM SOWIE ELEKTRISCHES SYSTEM

PROCÉDÉ DE SURVEILLANCE DE CHANGEMENT DE CAPACITÉ DANS UN SYSTÈME ÉLECTRIQUE ET UN TEL SYSTÈME

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**08.11.2017 Bulletin 2017/45**

(73) Proprietor: **ABB Schweiz AG**
**5400 Baden (CH)**

(72) Inventors:
 • **Viitanen, Tero**
  **00380 Helsinki (FI)**
 • **Alahuhtala, Jarno**
  **00380 Helsinki (FI)**
 • **Saarinen, Mikko**
  **00380 Helsinki (FI)**

(74) Representative: **Kolster Oy Ab**
**(Salmisaarenaukio 1)**
**P.O. Box 204**
**00181 Helsinki (FI)**

(56) References cited:
**EP-A1- 2 876 793    US-A- 5 910 892**
**US-B1- 6 381 158**

## Description

## Field of the invention

The invention relates to a method for monitoring a change in a capacitance in an electric system, and to an electric system.

## Background of the invention

An inverter is an electric device enabling conversion of DC (direct current) power from a DC power source to AC (alternating current) power. Herein term 'inverter' generally refers to an electric device or circuitry that is able to convert direct current to alternating current. An example of an inverter is a semiconductor bridge implemented by means of controllable semiconductor switches, such as IGBTs (Insulated-gate Bipolar Transistor) or FETs (Field-Effect Transistor), which are controlled according to a modulation or control scheme used.

Multi-level converters, such as inverters or rectifiers, have three DC poles. In addition to positive and negative DC poles, they have at least one middle DC pole at an electric potential between the positive DC pole and the negative DC pole. For example, a three-level converter has three DC poles; a positive DC pole, a negative DC pole, and one middle DC pole (a neutral DC pole). Examples of three-level converters are given in document: T. Brückner, S. Bernet and H. Güldner, "The Active NPC Converter and Its Loss-Balancing Control", IEEE Transactions on Industrial Electronics, Vol. 52, No. 3, June 2005. In particular, examples of three-level neutral-point-clamped (NPC) converters and active neutral-point-clamped (ANPC) converters are given.

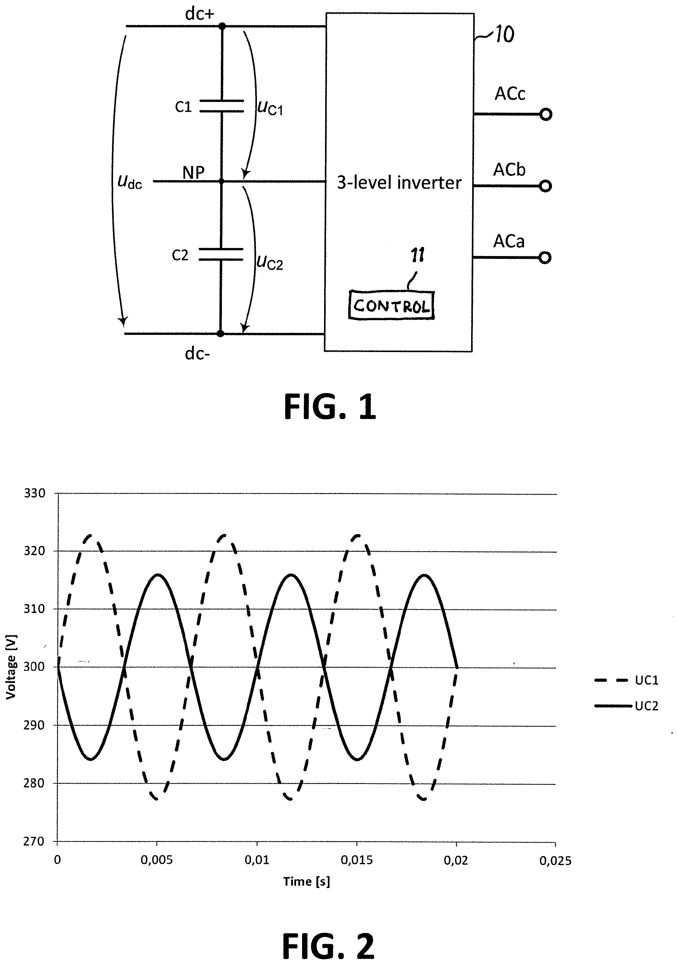

In use there is typically a series connection of capacitances connected between the negative DC pole and the positive DC pole of the multi-level converter such that each connection point between the capacitances is connected to one middle DC pole of the multi-level converter. For example, as illustrated in the example of Figure 1 showing a three-level inverter, there is a series connection of two capacitances C1, C2 between the negative DC pole dc- and the positive DC pole dc+, wherein the connection point between the two capacitances is connected to the middle DC pole NP of the inverter. The use of N capacitances thus provides N-1 middle DC potentials into which an AC output can be connected. As a result, the total number of available DC potentials will be N+1. Such a multi-level topology enables a better output AC voltage quality as the ripple of the output AC voltage produced can be reduced, for example.

The capacitances connected to the DC input of the inverter may start to decrease over time. For example, a common type of capacitor used is a film capacitor, in which the capacitance thereof tends to decrease over time as a result of the capacitor's self-healing process. In the self-healing process a conductor metallized on the surface of an insulating film vaporizes as a result of partial discharges through the insulation. The self-healing process produces detrimental hydrogen gases which may cause a danger of explosion upon build-up thereof. The capacitances may also decrease as a result of corona, which may be emphasized by moisture being absorbed to the insulation of the capacitor.

A problem related to the possible decrease of the capacitances over time is that if it is not monitored then the control dynamics of the inverter may suffer over time and there may also be a risk of explosion. The capacitances could be monitored by manually measuring them periodically. In practice, such a solution would be burdensome and costly.

US 6381158 discloses a system and method for monitoring DC link capacitance variance in three level inverters by injecting a signal into a neutral point regulator of a motor drive converter and measuring the response to the injected signal to monitor DC link capacitance.

## Brief description of the invention

An object of the invention is to provide a method and an apparatus for implementing the method so as to solve or at least alleviate the above problems. The object of the invention is achieved by a method, a computer program product, and an electric system that are characterised by what is stated in the independent claims. Preferred embodiments of the invention are described in the dependent claims.

The invention is based on an idea of providing by an inverter an AC current component to at least one middle DC pole of the inverter, which AC current component is distributed between two capacitances connected to the middle DC pole in question, and monitoring the resulting AC voltage components in each of the two capacitances, and then determining on the basis of a difference between the monitored AC voltage components a change in at least one of the two capacitances.

The solution of the invention provides the advantage that the capacitances connected to the DC input of the inverter can be easily monitored. In addition, the invention may be implemented by using existing system elements and hence any additional measuring devices are not necessarily needed.

## Brief description of the figures

The invention will now be explained in greater detail in connection with preferred embodiments and with reference to the attached drawings, in which:

Figure 1 shows an example of an electric system according to an embodiment; and
Figure 2 shows a voltage diagram according to an embodiment.

**Detailed description of the invention**

The application of the invention is not restricted to any specific system, but it may be applied to various electric systems comprising an inverter and capacitances connected to the DC input thereof. In addition, the use of the invention is not restricted to any specific basic frequency of the system or to any specific voltage level. While the following examples relate to a three-level inverter, the embodiments may be applied to any multilevel inverter.

Figure 1 shows an example of a main circuit of an electric system according to an embodiment. The number of various components may vary from that shown in the figure. The exemplary electric system comprises a three-phase three-level inverter 10, such as an NPC or ANPC inverter, having a DC input dc+, NP, dc-, and an AC output ACa, ACb, ACc. The inverter 10 could alternatively have only one phase, or more than three phases, for example. The exemplary electric system further comprises two capacitances C1, C2 connected in series between the negative DC pole dc- of the inverter and the positive DC pole dc+ of the inverter, wherein the connection point between the two capacitances is connected to the middle DC pole NP of the inverter. The total voltage $u_{dc}$ of the DC input is a sum of the voltages $u_{C1}$, $u_{C2}$ of the capacitances C1, C2, respectively. Each of the capacitances C1, C2 can comprise one or more capacitors. In case of more than one middle DC poles, the number of capacitances would be higher correspondingly. For example, a series connection of N capacitances could be used when there are N-1 middle DC poles in the inverter such that each connection point between two capacitances of the series connection is connected to a respective middle DC pole. Although the capacitances C1, C2 have been illustrated separate from the inverter 10, it is also possible that the capacitances C1, C2 are physically located inside the inverter 10, or that the capacitances C1, C2 and the inverter are located within a common housing, for example. The inverter 10 may be further connected to a DC supply via its DC input dc+, NP, dc-, and to other AC systems such as AC networks or AC loads via its AC output ACa, ACb, ACc. For the sake of clarity, these are not shown in the figure.

Figure 1 further shows a control arrangement 11 of the inverter 10 which can control the operation of the inverter 10. The control arrangement 11 may further perform measurements of or receive input signals regarding various quantities, such as current or voltage quantities, in order to perform the control of the inverter 10, for example. Possible measuring arrangements for such quantities are not shown in the figure for the sake of clarity. The control arrangement 11 of the inverter 10 can be used for implementing the functionality according to the various embodiments described herein. Alternatively, it would be possible to use a control arrangement separate from the inverter 10. For example, it would be possible to use additional or separate logical or physical units (not shown) for performing the control functionality of the various embodiments. The functionality of the various embodiments could, for example, be implemented using a separate logic arrangement, which could be at least partly independent of the normal control of the inverter 10, for example.

According to an embodiment, the monitoring of a change in a capacitance in the electric system comprises providing by the inverter 10 an AC voltage to the AC output ACa, ACb, ACc of the inverter from a DC voltage supplied to the DC input dc+, NP, dc- of the inverter 10. This may be part of the normal operation of the inverter 10 and include supplying AC power from the AC output to a load or an AC network, for example. Then, while the AC voltage is provided to the AC output of the inverter, an AC current component is provided by the inverter 10 to one of the at least one middle DC pole NP of the inverter 10, which AC current component is distributed between the two capacitances C1, C2 connected to the middle DC pole NP in question, and resulting AC voltage components in each of the two capacitances C1, C2 are monitored. The AC current component provided may be essentially of a predetermined or known frequency, for example. In other words, an AC current component is supplied by the inverter 10 through the middle DC pole NP such that the AC current component is divided between the two capacitances C1, C2. The AC current component is preferably divided essentially evenly between the two capacitances C1, C2. In this case, however, an instantaneous current component observed at a given time point is not necessarily evenly divided between the two capacitances C1, C2 but, instead, the current component observed over a period of time (e.g. an average of the current component) may be evenly distributed between the two capacitances C1, C2. Finally, a change in at least one of the two capacitances can be determined on the basis of a difference between the monitored AC voltage components in each of the two capacitances C1, C2. According to an embodiment, the change in the at least one of the two capacitances (C1, C2) can be determined by comparing the difference between the monitored AC voltage components to a predetermined threshold value or to a previously obtained difference value. Based on the comparison it can be determined that a change has taken place or a (relative or absolute) magnitude of the change can be determined, for example.

Thus, according to an aspect, the idea is to cause unbalance to the voltages of the capacitances C1, C2 from which a mutual magnitude of the capacitances and possible changes thereof can be determined. The unbalance can be caused with the AC current component provided by the inverter 10 to the at least one middle DC pole NP of the inverter. For example, if the resulting AC voltage components in each of the two capacitances C1, C2 differ from each other, the mutual magnitudes of the capacitances C1, C2 can be compared. Generally, a smaller capacitance has a larger voltage variation. As a result, a difference in the magnitudes of the resulting AC voltage components in the capacitances C1, C2 indicates that the magnitudes of the capacitances are different. If the capacitances C1, C2 are originally of the same value, as is typically the case, then a difference in the magnitudes of the resulting AC voltage components in the capacitances C1, C2 indicates a change in at least one of the capacitances from its original value. In a similar manner, if a difference in the magnitudes of the resulting AC voltage components in the capacitances C1, C2 is higher than a previously determined difference, this indicates a change in at least one of the capacitances from its previous value, for example. Figure 2 shows a voltage diagram according to an embodiment. In Figure 2 the resulting AC voltage components UC1, UC2 in each of the two capacitances C1, C2 are shown in a case where the magnitude of capacitance C1 is smaller than the magnitude of capacitance C2.

According to an embodiment, the inverter 10 is pulse width modulation (PWM) controlled according to a voltage reference and the AC current component is provided by including a predetermined zero sequence component (or common mode component) in the voltage reference or modulation reference of the inverter. When such a zero sequence component is implemented in a symmetrical manner, then also the resulting voltage deviation should be essentially symmetrical in both of the two capacitances C1, C2. If this is not the case, then it can be determined that the capacitances are of a different magnitude, for example. The adding of the zero sequence component typically causes short current pulses in the two capacitances C1, C2 due to the PWM. These current pulses in the two capacitances C1, C2 may circulate in the two capacitances C1, C2 simultaneously or non-simultaneously, as the case may be, and hence their instantaneous values may differ at a given time point. These current pulses then in turn cause a lower frequency current component which, on average, may be essentially evenly distributed between the capacitances C1, C2. As an example, when the inverter 10 is a three-level three-phase inverter having one middle DC pole NP, and the electric system comprises a first capacitance C1 connected between the positive DC pole of the inverter and the middle DC pole of the inverter and a second capacitance C2 connected between the middle DC pole of the inverter and the negative DC pole of the inverter, as shown in the example of Figure 1, the predetermined zero sequence component may comprise a third harmonic, or a multiple thereof, having a predetermined amplitude and phase difference with respect to a fundamental AC voltage. In this case the added harmonic causes an AC voltage component of the same frequency to both of the capacitances C1, C2. And, because the added harmonic and the resulting phase currents are symmetrical, a difference, if any, in the magnitudes of the voltages will indicate that there is a difference in the magnitudes of the capacitances. According to an embodiment, such adding of the third harmonic $U_3$ (or a multiple thereof) to the fundamental frequency voltage reference $U_1$ of the

inverter may be implemented by using a modified voltage reference $U_{mod} = U_1 + U_3$ in the inverter 10, where:

$$U_1 = a*\sin(\omega t),$$

and

$$U_3 = Amp3*\sin(3\omega t + Phi3),$$

where

a = amplitude of the voltage reference,
$\omega$ = angular velocity,
t = time,
Amp3 = amplitude of the third harmonic, and
Phi3 = phase difference of the third harmonic.

According to an embodiment, the determination of the change in the at least one of the two capacitances C1, C2 on the basis of a difference between the monitored resulting AC voltage components in each of the two capacitances C1, C2 may comprise comparing the magnitudes of the monitored AC voltage components in the two capacitances C1, C2, to each other in order to obtain a difference between the magnitudes of the monitored AC voltage components. In that case the magnitude of the AC voltage components may be peak-to-peak values, maximum values, minimum values or average values, for example. The voltages of the capacitances C1, C2 typically comprise an essentially constant DC component, which is typically approximately equal in the two capacitances, and a negligible PWM frequency AC component. The frequency of the PWM frequency AC component is higher than the frequency of the AC current component provided to the capacitances and hence it may be preferable to filter the measured AC voltages of the capacitances when performing the monitoring of the resulting AC voltage components in the capacitances C1, C2. Thus, the magnitudes of the monitored AC voltage components may be filtered peak-to-peak values over a predetermined period of time, for example. Generally the obtained difference between the magnitudes of the monitored AC voltage components in the two capacitances C1, C2 is proportional to the difference of the magnitudes of the capacitances and hence may be used to detect a change in at least one of the two capacitances. The obtained difference between the magnitudes of the monitored AC voltage components in the two capacitances C1, C2 may be used to update a corresponding parameter or parameters used in the inverter control, for example. Alternatively or additionally, it may be used to monitor the condition of the at least one capacitance according to a predetermined life cycle curve provided by the component manufacturer or according to predetermined typical operating point quantities, for example. For example, if the obtained difference between the magnitudes of the monitored AC voltage components in the two capacitances C1, C2 is higher than a predetermined threshold or a previously obtained difference value, it may be concluded that the condition of the at least one capacitance has changed notably or significantly. It is then possible to create a notification or an alarm to a user of the system and/or trigger automatic safety procedures, such as stopping the inverter, for example.

According to an embodiment, if the inverter 10 has more than one middle DC pole then the providing of the AC current component and the determining of a change in the at least one of the two capacitances are performed for each middle DC pole and the respective capacitances connected thereto. Moreover, according to an embodiment, the determination of a change in the at least one capacitance according to any of the embodiments described herein may be performed at predetermined intervals or continuously, when the inverter 10 is in operation, for example. Also, the AC current component provided to the at least one middle DC pole of the inverter may be provided solely for the purpose of determining a change in the at least one of the two capacitances or such AC current component may result from the normal operation of the inverter 10.

The control arrangement 11 and/or a possible separate control arrangement can be implemented as one unit or as two or more separate units that are configured to implement the functionality of the various embodiments described herein. Here the term 'unit' refers generally to a physical or logical entity, such as a physical device or a part thereof or a software routine. The control arrangement 11 according to any one of the embodiments may be implemented at least partly by means of one or more computers or corresponding digital signal processing (DSP) equipment provided with suitable software, for example. Such a computer or digital signal processing equipment preferably comprises at least a working memory (RAM) providing a storage area for arithmetical operations, and a central processing unit (CPU), such as a general-purpose digital signal processor. The CPU may comprise a set of registers, an arithmetic logic unit, and a CPU control unit. The CPU control unit is controlled by a sequence of program instructions transferred to the CPU from the RAM. The CPU control unit may contain a number of microinstructions for basic operations. The implementation of microinstructions may vary depending on the CPU design. The program instructions may be coded by a programming language, which may be a high-level programming language, such as C, Java, etc., or a low-level programming language, such as a machine language, or an assembler. The computer may also have an operating system which may provide system services to a computer program written with the program instructions. The computer or other apparatus implementing the invention, or a part thereof, may further comprise suitable input means for receiving measurement and/or control data, for example, and output means for outputting control data, for example. It is also possible to use analog circuits, programmable logic devices (PLD), or discrete electric components and devices for implementing the functionality according to any one of the embodiments. For example, the control arrangement 11 according to any one of the embodiments may be implemented at least partly by means of such analog circuits or programmable logic devices.

The invention can be implemented in existing system elements or by using separate dedicated elements or devices in a centralized or distributed manner. Present inverters or generally converter devices, for example, can comprise programmable logic devices, or processors and memory that can be utilized in the functions according to embodiments of the invention. Thus, all modifications and configurations required for implementing an embodiment e.g. in existing inverters may be performed as software routines, which may be implemented as added or updated software routines. If at least part of the functionality of the invention is implemented by software, such software can be provided as a computer program product comprising computer program code which, when run on a computer, causes the computer or a corresponding arrangement to perform the functionality according to the invention as described above. Such a computer program code may be stored or generally embodied on a computer readable medium, such as a suitable memory, a flash memory or an optical memory, for example, from which it is loadable to the unit or units executing the program code. In addition, such a computer program code implementing the invention may be loaded to the unit or units executing the computer program code via a suitable data network, for example, and it may replace or update a possibly existing program code.

It is obvious to a person skilled in the art that, as technology advances, the basic idea of the invention may be implemented in various ways. The invention and its embodiments are thus not restricted to the above examples but may vary within the scope of the claims.

**Claims**

1. A method for monitoring a change in a capacitance in an electric system, the electric system comprising a multilevel inverter (10) having a DC input comprising a positive DC pole (dc+), a negative DC pole (dc-), and at least one middle DC pole (NP) at an electric potential between the positive DC pole and the negative DC pole, and an AC output (ACa, ACb, ACc), wherein the inverter (10) is pulse width modulation controlled according to a voltage reference, and at least two capacitances (C1, C2) connected in series between the negative DC pole of the inverter and the positive DC pole of the inverter, wherein the connection point between the at least two capacitances is connected to one of the at least one middle DC pole of the inverter, the method comprising:

a) providing by the inverter (10) an AC voltage to the AC output (ACa, ACb, ACc) of the inverter from a DC voltage supplied to the DC input of the inverter,

**characterized in that** the method comprises:

b) providing by the inverter (10), while providing the AC voltage to the AC output (ACa, ACb, ACc) of the inverter, an AC current component to one of the at least one middle DC pole (NP) of the inverter, which AC current component is distributed between the two capacitances (C1, C2) connected to the middle DC pole in question, wherein the AC current component is provided by including a predetermined zero sequence component to the voltage reference or modulation reference of the inverter, and monitoring resulting AC voltage components in each of the two capacitances; and

c) determining on the basis of a difference between the monitored AC voltage components a change in at least one of the two capacitances (C1, C2).

2. A method according to claim 1, wherein in step c) the change in the at least one of the two capacitances (C1, C2) is determined by comparing the difference between the monitored AC voltage components to a predetermined threshold value or to a previously obtained difference value.

3. A method according to claim 1 or 2, wherein the inverter (10) is a three-level three-phase inverter having one middle DC pole (NP) and the electric system comprises a first capacitance (C1) connected between the positive DC pole (dc+) of the inverter and the middle DC pole of the inverter and a second capacitance (C2) connected between the middle DC pole of the inverter and the negative DC pole (dc-) of the inverter, and wherein the predetermined zero sequence component comprises a third harmonic, or a multiple thereof, having a predetermined amplitude and phase difference with respect to a fundamental AC voltage.

4. A method according to claim 1 or 2, wherein the inverter (10) has more than one middle DC pole (NP) and steps c) and d) are performed for each middle DC pole and the respective capacitances (C1, C2) connected thereto.

5. A method according to any one of claims 1 to 4, wherein steps b) and c) are performed continuously during step a) or at predetermined intervals.

6. A method according to any one of claims 1 to 5, wherein the monitoring of the AC voltage components in the capacitances (C1, C2) comprises filtering measured voltage signals.

7. A computer program product comprising computer program code, wherein execution of the program code on a computer causes the computer, when controlling an inverter, to carry out the steps of the method according to any one of claims 1 to 6.

8. An electric system comprising:

a multilevel inverter (10) having a DC input comprising a positive DC pole (dc+), a negative DC pole (dc-), and at least one middle DC pole (NP) at an electric potential between the positive DC pole and the negative DC pole, and an AC output (ACa, ACb, ACc), wherein the inverter (10) is pulse width modulation controlled according to a voltage reference;

at least two capacitances (C1, C2) connected in series between the negative DC pole (dc-) of the inverter and the positive DC pole (dc+) of the inverter, wherein the connection point between the at least two capacitances is connected to one of the at least one middle DC pole (NP) of the inverter; and

control means (11) configured to:

provide by the inverter (10) an AC voltage to the AC output (ACa, ACb, ACc) of the inverter from a DC voltage supplied to the DC input of the inverter,

**characterized in that** the control means (11) are configured to:

provide by the inverter (10), while providing the AC voltage to the AC output (ACa, ACb, ACc) of the inverter, an AC current component to one of the at least one middle DC pole (NP) of the inverter, which AC current component is distributed between the two capacitances (C1, C2) connected to the middle DC pole in question, wherein the control means (11) are configured to provide the AC current component by including a predetermined zero sequence component to the voltage reference or modulation reference of the inverter (10), and monitor resulting AC voltage components in each of the two capacitances; and

determine on the basis of a difference between the monitored AC voltage components a change in at least one of the two capacitances (C1, C2).

9. An electric system according to claim 8, wherein control means (11) are configured to determine the change in the at least one of the two capacitances (C1, C2) by comparing the difference between the monitored AC voltage components to a predetermined threshold value or to a previously obtained difference value.

10. An electric system according to claim 8 or 9, wherein the inverter (10) is a three-level three-phase inverter having one middle DC pole (NP) and the electric system comprises a first capacitance (C1) connected between the positive DC pole (dc+) of the inverter and the middle DC pole of the inverter and a second capacitance (C2) connected between the middle DC pole of the inverter and the negative DC pole (dc-) of the inverter, and wherein the predetermined zero sequence component comprises a third harmonic, or a multiple thereof, having a predetermined amplitude and phase difference with respect to a fundamental AC voltage.

11. An electric system according to claim 8 or 9, wherein the inverter (10) has more than one middle DC pole (NP) and the control means (11) are configured to perform the providing of the AC current component and the determining of the change in the at least one of the two capacitances (C1, C2) for each middle DC pole and the respective capacitances connected thereto.

12. An electric system according to any one of claims 8 to 11, wherein the control means (11) are configured to perform the providing of the AC current component and the determining of the change in the at least one of the two capacitances (C1, C2) continuously during the providing of the AC voltage or at predetermined intervals.

13. An electric system according to any one of claims 8 to 12, wherein the control means (11) are configured to filter measured voltage signals during the monitoring of the AC voltage components in the capacitances (C1, C2).

14. An electric system according to any one of claims 8 to 13, wherein the inverter (10) is a neutral-point-clamped inverter or an active neutral-point-clamped inverter.

**Patentansprüche**

1. Verfahren zum Überwachen einer Änderung in einer Kapazität in einem elektrischen System, wobei das elektrische System einen mehrstufigen Wechselrichter (10) mit einem Gleichstromeingang, der einen positiven Gleichstrompol (dc+), einen negativen Gleichstrompol (dc-) und mindestens einen mittleren Gleichstrompol (NP) auf einem elektrischen Potential zwischen dem positiven Gleichstrompol und dem negativen Gleichstrompol umfasst, und einen Wechselstromausgang (ACa, ACb, ACc) umfasst, wobei der Wechselrichter (10) gemäß einer Spannungsreferenz pulsbreitenmoduliert gesteuert wird, und mindestens zwei Kapazitäten (C1, C2) zwischen dem negativen Gleichstrompol des Wechselrichters und dem positiven Gleichstrompol des Wechselrichters in Reihe geschaltet sind, wobei der Verbindungspunkt zwischen den mindestens zwei Kapazitäten mit einem vom mindestens einen mittleren Gleichstrompol des Wechselrichters verbunden ist, wobei das Verfahren umfasst:

a) Bereitstellen durch den Wechselrichter (10) einer Wechselspannung an den Wechselstromausgang (ACa, ACb, ACc) des Wechselrichters aus einer Gleichspannung, die dem Gleichstromeingang des Wechselrichters zugeführt wird,

**dadurch gekennzeichnet, dass** das Verfahren Folgendes umfasst:

b) Bereitstellen durch den Wechselrichter (10), während die Wechselspannung an den Wechselstromausgang (ACa, ACb, ACc) des Wechselrichters bereitgestellt wird, einer Wechselstromkomponente an einen vom mindestens einen mittleren Gleichstrompol (NP) des Wechselrichters, wobei die Wechselstromkomponente zwischen den zwei Kapazitäten (C1, C2), die mit dem betreffenden mittleren Gleichstrompol verbunden sind, verteilt wird, wobei die Wechselstromkomponente dadurch bereitgestellt wird, dass eine vorbestimmte Nullkomponente in die Spannungsreferenz oder die Modulationsreferenz des Wechselrichters eingefügt wird, und die resultierenden Wechselspannungskomponenten in jeder der zwei Kapazitäten überwacht werden; und
c) Bestimmen auf der Grundlage einer Differenz zwischen den überwachten Wechselspannungskomponenten einer Änderung in mindestens einer der zwei Kapazitäten (C1, C2) .

2. Verfahren nach Anspruch 1, wobei in Schritt c) die Änderung in der mindestens einen der zwei Kapazitäten (C1, C2) durch Vergleichen der Differenz zwischen den überwachten Wechselspannungskomponenten mit einem vorgegebenen Schwellenwert oder mit einem zuvor erhaltenen Differenzwert bestimmt wird.

3. Verfahren nach Anspruch 1 oder 2, wobei der Wechselrichter (10) ein dreistufiger Dreiphasen-Wechselrichter mit einem mittleren Gleichstrompol (NP) ist und das elektrische System eine erste Kapazität (C1), die zwischen dem positiven Gleichstrompol (dc+) des Wechselrichters und dem mittleren Gleichstrompol des Wechselrichters verbunden ist, und eine zweite Kapazität (C2) umfasst, die zwischen dem mittleren Gleichstrompol des Wechselrichters und dem negativen Gleichstrompol (dc-) des Wechselrichters verbunden ist, und wobei die vorbestimmte Nullkomponente eine dritte Harmonische, oder ein Vielfaches davon, mit einer vorbestimmten Amplitude und Phasendifferenz bezüglich einer Grundwechselspannung umfasst.

4. Verfahren nach Anspruch 1 oder 2, wobei der Wechselrichter (10) mehr als einen mittleren Gleichstrompol (NP) aufweist und die Schritte c) und d) für jeden mittleren Gleichstrompol und die jeweiligen damit verbundenen Kapazitäten (C1, C2) durchgeführt werden.

5. Verfahren nach einem der Ansprüche 1 bis 4, wobei die Schritte b) und c) kontinuierlich während des Schrittes a) oder in vorbestimmten Intervallen durchgeführt werden.

6. Verfahren nach einem der Ansprüche 1 bis 5, wobei die Überwachung der Wechselspannungskomponenten in den Kapazitäten (C1, C2) das Filtern von gemessenen Spannungssignalen umfasst.

7. Computerprogrammprodukt umfassend Computerprogrammcode, wobei die Ausführung des Programmcodes auf einem Computer den Computer veranlasst, beim Steuern eines Wechselrichters die Schritte des Verfahrens nach einem der Ansprüche 1 bis 6 auszuführen.

8. Elektrisches System, umfassend:

einen mehrstufigen Wechselrichter (10) mit einem Gleichstromeingang, der einen positiven Gleichstrompol (dc+), einen negativen Gleichstrompol (dc-) und mindestens einen mittleren Gleichstrompol (NP) auf einem elektrischen Potential zwischen dem positiven Gleichstrompol und dem negativen Gleichstrompol umfasst, und einem Wechselstromausgang (ACa, ACb, ACc), wobei der Wechselrichter (10) gemäß einer Spannungsreferenz pulsbreitenmoduliert gesteuert wird;
mindestens zwei Kapazitäten (C1, C2), die zwischen dem negativen Gleichstrompol (dc-) des Wechselrichters und dem positiven Gleichstrompol (dc+) des Wechselrichters in Reihe verbunden sind, wobei der Verbindungspunkt zwischen den mindestens zwei Kapazitäten mit einem vom mindestens einen mittleren Gleichstrompol (NP) des Wechselrichters verbunden ist; und
Steuermittel (11), die für Folgendes ausgelegt sind:
Bereitstellen durch den Wechselrichter (10) einer Wechselspannung an den Wechselstromausgang (ACa, ACb, ACc) des Wechselrichters aus einer Gleichspannung, die dem Gleichstromeingang des Wechselrichters zugeführt wird, **dadurch gekennzeichnet, dass** die Steuermittel (11) für Folgendes ausgelegt sind:

Bereitstellen durch den Wechselrichter (10), während die Wechselspannung an den Wechselstromausgang (ACa, ACb, ACc) des Wechselrichters bereitgestellt wird, einer Wechselstromkomponente an einen vom mindestens einen mittleren Gleichstrompol (NP) des Wechselrichters, wobei die Wechselstromkomponente zwischen den zwei Kapazitäten (C1, C2), die mit dem betreffenden mittleren Gleichstrompol verbunden sind, verteilt wird, wobei die Steuermittel (11) dafür ausgelegt sind, die Wechselstromkomponente durch Einfügen einer vorbestimmten Nullkomponente in die Spannungsreferenz oder die Modulationsreferenz des Wechselrichters (10) und Überwachen der resultierenden Wechselspannungskomponenten in jeder der zwei Kapazitäten bereitzustellen; und
Bestimmen auf der Grundlage einer Differenz zwischen den überwachten Wechselspannungskomponenten einer Änderung in mindestens einer der zwei Kapazitäten (C1, C2).

9. Elektrisches System nach Anspruch 8, wobei die Steuermittel (11) dafür ausgelegt sind, die Änderung in der mindestens einen der zwei Kapazitäten (C1, C2) durch Vergleich der Differenz zwischen den überwachten Wechselspannungskomponenten mit einem vorbestimmten Schwellenwert oder mit einem zuvor erhaltenen Differenzwert zu bestimmen.

10. Elektrisches System nach Anspruch 8 oder 9, wobei der Wechselrichter (10) ein dreistufiger Dreiphasen-Wechselrichter mit einem mittleren Gleichstrompol (NP) ist und das elektrische System eine erste Kapazität (C1), die zwischen dem positiven Gleichstrompol (dc+) des Wechselrichters und dem mittleren Gleichstrompol des Wechselrichters verbunden ist, und eine zweite Kapazität (C2) umfasst, die zwischen dem mittleren Gleichstrompol des Wechselrichters und dem negativen Gleichstrompol (dc-) des Wechselrichters verbunden ist, und wobei die vorbestimmte Nullkomponente eine dritte Harmonische, oder ein Vielfaches davon, mit einer vorbestimmten Amplitude und Phasendifferenz bezüglich einer Grundwechselspannung umfasst.

**11.** Elektrisches System nach Anspruch 8 oder 9, wobei der Wechselrichter (10) mehr als einen mittleren Gleichstrompol (NP) aufweist und die Steuermittel (11) dafür ausgelegt sind, das Bereitstellen der Wechselstromkomponente und das Bestimmen der Änderung in der mindestens einen der zwei Kapazitäten (C1, C2) für jeden mittleren Gleichstrompol und die jeweiligen damit verbundenen Kapazitäten durchzuführen.

**12.** Elektrisches System nach einem der Ansprüche 8 bis 11, wobei die Steuermittel (11) dafür ausgelegt sind, das Bereitstellen der Wechselstromkomponente und das Bestimmen der Änderung in der mindestens einen der zwei Kapazitäten (C1, C2) kontinuierlich während des Bereitstellens der Wechselspannung oder in vorbestimmten Intervallen durchzuführen.

**13.** Elektrisches System nach einem der Ansprüche 8 bis 12, wobei die Steuermittel (11) dafür ausgelegt sind, gemessene Spannungssignale während des Überwachens der Wechselspannungskomponenten in den Kapazitäten (C1, C2) zu filtern.

**14.** Elektrisches System nach einem der Ansprüche 8 bis 13, wobei der Wechselrichter (10) ein Wechselrichter mit Neutralpunkt-Klemmung oder ein aktiver Wechselrichter mit Neutralpunkt-Klemmung ist.

**Revendications**

**1.** Procédé permettant de surveiller une variation d'une capacité dans un système électrique, le système électrique comprenant un onduleur multiniveau (10) possédant une entrée c.c. comprenant un pôle c.c. positif (dc+), un pôle c.c. négatif (dc-) et au moins un pôle c.c. neutre (NP) à un potentiel électrique entre le pôle c.c. positif et le pôle c.c. négatif, et une sortie c.a. (ACa, ACb, ACc), dans lequel l'onduleur (10) est commandé par modulation d'impulsions en durée en fonction d'une référence de tension, et au moins deux capacités (C1, C2) connectées en série entre le pôle c.c. négatif de l'onduleur et le pôle c.c. positif de l'onduleur, dans lequel le point de connexion entre les au moins deux capacités est connecté à un de l'au moins un pôle c.c. neutre de l'onduleur, le procédé consistant à :

a) fournir, par l'onduleur (10), une tension alternative à la sortie c.a. (ACa, ACb, ACc) de l'onduleur à partir d'une tension continue fournie à l'entrée c.c. de l'onduleur,

**caractérisé en ce que** le procédé consiste à :

b) fournir, par l'onduleur (10), tout en fournissant la tension alternative à la sortie c.a. (ACa, ACb, ACc) de l'onduleur, une composante de courant alternatif à un de l'au moins un pôle c.c. neutre (NP) de l'onduleur, laquelle composante de courant alternatif est distribuée entre les deux capacités (C1, C2) connectées au pôle c.c. neutre en question, dans lequel la composante de courant alternatif est fournie par l'inclusion d'une composante de séquence nulle prédéfinie à la référence de tension ou la référence de modulation de l'onduleur, et la surveillance des composantes de tension alternative ainsi obtenues dans chacune des deux capacités ; et
c) déterminer, sur la base d'une différence entre les composantes de tension alternative surveillées, une variation d'au moins une des deux capacités (C1, C2).

**2.** Procédé selon la revendication 1, dans lequel, à l'étape c), la variation de l'au moins une des deux capacités (C1, C2) est déterminée en comparant la différence entre les composantes de tension alternative surveillées avec une valeur de seuil prédéfinie ou avec une valeur de différence précédemment obtenue.

**3.** Procédé selon la revendication 1 ou 2, dans lequel l'onduleur (10) est un onduleur triphasé à trois niveaux possédant un pôle c.c. neutre (NP) et le système électrique comprend une première capacité (C1) connectée entre le pôle c.c. positif (dc+) de l'onduleur et le pôle c.c. neutre de l'onduleur et une seconde capacité (C2) connectée entre le pôle c.c. neutre de l'onduleur et le pôle c.c. négatif (dc-) de l'onduleur, et dans lequel la composante de séquence nulle prédéfinie comprend une troisième harmonique, ou un multiple de celle-ci, ayant une amplitude et un déphasage prédéfinis par rapport à une tension alternative fondamentale.

**4.** Procédé selon la revendication 1 ou 2, dans lequel l'onduleur (10) possède plus d'un pôle c.c. neutre (NP) et les étapes c) et d) sont exécutées pour chaque pôle c.c. neutre et les capacités (C1, C2) respectives qui sont connectées à ceux-ci.

**5.** Procédé selon l'une quelconque des revendications 1 à 4, dans lequel les étapes b) et c) sont exécutées en continu pendant l'étape a) ou à intervalles prédéfinis.

**6.** Procédé selon l'une quelconque des revendications 1 à 5, dans lequel la surveillance des composantes de tension alternative dans les capacités (C1, C2) consiste à filtrer des signaux de tension mesurés.

**7.** Produit-programme informatique comprenant un code de programme informatique, dans lequel l'exécution du code de programme sur un ordinateur amène l'ordinateur, lors de la commande d'un onduleur, à réaliser les étapes du procédé selon l'une quelconque des revendications 1 à 6.

8. Système électrique comprenant :

un onduleur multiniveau (10) possédant une entrée c.c. comprenant un pôle c.c. positif (dc+), un pôle c.c. négatif (dc-) et au moins un pôle c.c. neutre (NP) à un potentiel électrique entre le pôle c.c. positif et le pôle c.c. négatif, et une sortie c.a. (ACa, ACb, ACc), dans lequel l'onduleur (10) est commandé par modulation d'impulsions en durée en fonction d'une référence de tension ;
au moins deux capacités (C1, C2) connectées en série entre le pôle c.c. négatif (dc-) de l'onduleur et le pôle c.c. positif (dc+) de l'onduleur, dans lequel le point de connexion entre les au moins deux capacités est connecté à un de l'au moins un pôle c.c. neutre (NP) de l'onduleur ; et
des moyens de commande (11) conçus pour :
fournir, par l'onduleur (10), une tension alternative à la sortie c.a. (ACa, ACb, ACc) de l'onduleur à partir d'une tension continue fournie à l'entrée c.c. de l'onduleur,
**caractérisé en ce que** les moyens de commande (11) sont conçus pour :

fournir, par l'onduleur (10), tout en fournissant la tension alternative à la sortie c.a. (ACa, ACb, ACc) de l'onduleur, une composante de courant alternatif à un de l'au moins un pôle c.c. neutre (NP) de l'onduleur, laquelle composante de courant alternatif est distribuée entre les deux capacités (C1, C2) connectées au pôle c.c. neutre en question, dans lequel les moyens de commande (11) sont conçus pour fournir la composante de courant alternatif par l'inclusion d'une composante de séquence nulle prédéfinie à la référence de tension ou la référence de modulation de l'onduleur (10), et surveiller des composantes de tension alternative ainsi obtenues dans chacune des deux capacités ; et
déterminer, sur la base d'une différence entre les composantes de tension alternative surveillées, une variation d'au moins une des deux capacités (C1, C2).

9. Système électrique selon la revendication 8, dans lequel les moyens de commande (11) sont conçus pour déterminer la variation de l'au moins une des deux capacités (C1, C2) en comparant la différence entre les composantes de tension alternative surveillées avec une valeur de seuil prédéfinie ou avec une valeur de différence précédemment obtenue.

10. Système électrique selon la revendication 8 ou 9, dans lequel l'onduleur (10) est un onduleur triphasé à trois niveaux possédant un pôle c.c. neutre (NP) et le système électrique comprend une première capacité (C1) connectée entre le pôle c.c. positif (dc+) de l'onduleur et le pôle c.c. neutre de l'onduleur et une seconde capacité (C2) connectée entre le pôle c.c. neutre de l'onduleur et le pôle c.c. négatif (dc-) de l'onduleur, et dans lequel la composante de séquence nulle prédéfinie comprend une troisième harmonique, ou un multiple de celle-ci, ayant une amplitude et un déphasage prédéfinis par rapport à une tension alternative fondamentale.

11. Système électrique selon la revendication 8 ou 9, dans lequel l'onduleur (10) possède plus d'un pôle c.c. neutre (NP) et les moyens de commande (11) sont conçus pour réaliser la fourniture de la composante de courant alternatif et la détermination de la variation de l'au moins une des deux capacités (C1, C2) pour chaque pôle c.c. neutre et les capacités respectives connectées à ceux-ci.

12. Système électrique selon l'une quelconque des revendications 8 à 11, dans lequel les moyens de commande (11) sont conçus pour réaliser la fourniture de la composante de courant alternatif et la détermination de la variation de l'au moins une des deux capacités (C1, C2) en continu pendant la fourniture de la tension alternative ou à intervalles prédéfinis.

13. Système électrique selon l'une quelconque des revendications 8 à 12, dans lequel les moyens de commande (11) sont conçus pour filtrer des signaux de tension mesurés pendant la surveillance des composantes de tension alternative dans les capacités (C1, C2).

14. Système électrique selon l'une quelconque des revendications 8 à 13, dans lequel l'onduleur (10) est un onduleur de type NPC (neutral-point-clamped) ou un onduleur de type NPC (neutral-point-clamped) actif.

**FIG. 1**

**FIG. 2**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6381158 B

**Non-patent literature cited in the description**

- **T. BRÜCKNER ; S. BERNET ; H. GÜLDNER.** The Active NPC Converter and Its Loss-Balancing Control. *IEEE Transactions on Industrial Electronics,* June 2005, vol. 52 (3